(19) Europäisches Patentamt
European Patent Office
Office européen des brevets

(11) **EP 1 150 131 B1**

## (12) EUROPÄISCHE PATENTSCHRIFT

(45) Veröffentlichungstag und Bekanntmachung des Hinweises auf die Patenterteilung:
**17.06.2009 Patentblatt 2009/25**

(51) Int Cl.:
***G01R 31/36*** *(2006.01)*

(21) Anmeldenummer: **01104989.7**

(22) Anmeldetag: **01.03.2001**

(54) **Verfahren zur Ermittlung des Ladezustands und der Belastbarkeit eines elektrischen Akkumulators**

Method for determining the state of the charge and the capacity of an electric storage battery

Procedé pour déterminer l'état de charge et la capacité d'un accumulateur électrique

(84) Benannte Vertragsstaaten:
**AT BE CH CY DE DK ES FI FR GB GR IE IT LI LU MC NL PT SE TR**

(30) Priorität: **29.04.2000 DE 10021161**

(43) Veröffentlichungstag der Anmeldung:
**31.10.2001 Patentblatt 2001/44**

(73) Patentinhaber: **VB Autobatterie GmbH & Co. KGaA**
**30419 Hannover (DE)**

(72) Erfinder:
• **Laig-Hörstebrock, Helmut, Dr.**
**60320 Frankfurt (DE)**
• **Meissner, Eberhard, Dr.**
**31515 Wunstorf (DE)**

• **Richter, Gerolf, Dr.**
**31139 Hildesheim (DE)**

(74) Vertreter: **Lins, Edgar et al**
**Gramm, Lins & Partner GbR**
**Theodor-Heuss-Strasse 1**
**38122 Braunschweig (DE)**

(56) Entgegenhaltungen:
**WO-A-90/13823**

• **PATENT ABSTRACTS OF JAPAN vol. 016, no. 323 (P-1386), 15. Juli 1992 (1992-07-15) & JP 04 095788 A (SHIN KOBE ELECTRIC MACH CO LTD), 27. März 1992 (1992-03-27)**

**Beschreibung**

Gegenstand der Erfindung ist ein Verfahren zur Ermittlung der Belastbarkeit eines elektrischen Akkumulators durch Messung von Strom, Spannung und Temperatur und Vergleich der gemessenen Spannungen mit den entsprechenden mit einem Ersatzschaltbild-Modell des Akkumulators berechneten Spannungen, wobei die Parameter der Komponenten des Ersatzschaltbild-Modells oder Ladezustände des Akkumulators derart variiert werden, dass Übereinstimmung mit den gemessenen Werten hergestellt wird und dass aus den so ermittelten angepassten Parametern oder angepasstem Ladezustand auf die Belastbarkeit geschlossen wird.

Für den Anwender von Akkumulatoren ist es von besonderer Bedeutung, über ausreichend genaue Verfahren zur Bestimmung der Belastbarkeit und Verfügbarkeit eines Akkumulators für eine bestimmte Anwendung zu verfügen. Erforderlich ist diese Bestimmung beispielsweise bei Elektroantrieb und Elektro-Hybridantrieb eines Kraftfahrzeugs, für die Bewertung der Startfähigkeit eines Verbrennungsmotors, für die Verfügbarkeit der Stromversorgung für Komponenten wie der elektrisch betriebenen oder angesteuerten Bremssysteme, Lenksysteme und Lenkhilfen, Stabilisierungssysteme und für sonstige wichtige Funktionen, aber auch für die Ansteuerungen von Komponenten zur Steuerung und Regelung von elektrischen Bauteilen, insbesondere der Lastzuschaltung und Lastabschaltung und der Spannungsregelung, sowie für Anzeigegeräte, die den Betreiber des Fahrzeugs über den Betriebszustand informieren.

Zur Messung des Ladezustands von Akkumulatoren sind die verschiedensten Verfahren bekannt.

In vielen Fällen werden integrierende Messgeräte (Stromzähler) benutzt. Diese Verfahren zeigen bei Akkumulatoren im Anwendungsbereich kompletter Ladung und Entladung mit nur seltenen Zwischenladungen sehr gute Erfolge. Fehler können entstehen durch Mess- und Rechenungenauigkeiten, parasitäre Ladungsverluste im Akkumulator, die Alterung des Akkumulators sowie sich mit der Höhe des Lade- bzw. Entladestroms ändernde entnehmbare Akkumulatorkapazitäten. Allerdings ist es mit Hilfe solcher integrierender Verfahren nicht möglich, eine zuverlässige Aussage über die aktuelle Leistung (Produkt Strom mal Spannung) des Akkumulators zu machen, da z. B. die Änderung des Innenwiderstands eine Funktion der hinsichtlich Zeitdauer und Stromhöhe vorausgegangenen Voll- bzw. Teilzyklen ist.

Die erwähnten Schwachpunkte der Ladungsbilanzierungsmethode können durch eine mathematische Modellbildung des Akkumulators weitgehend überwunden werden. Verfahren mit mathematischen Modellen (beschreibenden Gleichungen bzw. mathematisch darstellbaren Ersatzschaltbildern), deren Auswertung auf elektronischen Rechenanlagen bei Vorgabe eines Satzes von batterietypischen Grunddaten bzw. Ersatzschaltbildkomponentendaten erfolgt, machen eine Ladezustandserfassung des parallel zum Model zeitgleich betriebenen Akkumulators möglich. Limitierender Faktor dieser Methoden ist lediglich die Güte des zugrunde liegenden Modells, sowie die Qualität der Eingabeparameter hinsichtlich ihrer Übereinstimmung mit dem zu betrachtenden Akkumulator.

Als Auswertemethode hat sich insbesondere der regelungstechnische Nullabgleich der über das Modell errechneten Ausgangsspannung mit der tatsächlichen Akkumulatorspannung unter den Bedingungen gleicher Temperatur und gleichen Stromdurchsatzes als besonders brauchbar erwiesen. Diese Art der Auswertung lässt auch eine Abschätzung der Alterungsvorgänge im Akkumulator zu.

Derartige Verfahren sind beispielsweise der EP 471698 B1 (=WO 90/13823) zu entnehmen, gemäß der die Prozesseingangsgrößen (Spannung, Strom, Temperatur) des Akkumulators gemessen und in einem Rechner verarbeitet werden, wobei nach dem Prinzip des indirekten Messens ein vorgebbares Modell in Form mehrparametriger Funktionen, das den Ladezustand und die zu bestimmenden physikalischen Größen und ihre physikalischen Beziehungen zueinander repräsentiert mit den gemessenen Prozesseingangsgrößen verglichen wird und für die nachfolgende Messung im Falle von Abweichungen die Modellparameter adaptiert werden. Zur Ermittlung des Ladezustandes wird beispielsweise eine vielparametrige Beschreibung in Form eines Modells verwendet.

Über die tatsächliche Ausgestaltung des Ersatzschaltbild-Modells lassen sich dieser Druckschrift keine näheren Angaben entnehmen.

Dem Dokument "Ladezustandsschätzung von Bleibatterien mit Hilfe des Kalman-Filters" von P. Lürkens und W. Steffens (ETZ Archiv Band 8 (1986) Heft 7 Seiten 231-236) ist ein Verfahren zur Bestimmung des Ladezustands zu entnehmen, bei dem die Methode der Zustandsschätzung mit Hilfe des Kalman-Filters Verwendung findet. In der Druckschrift ist auch ein geeignetes Ersatzschaltbild für einen Bleiakkumulator angegeben,

In der JP 04 095 788 A ist die Verwendung einer Warburg-Impedanz für eine Äquivalentschaltung beschrieben, die zur Beurteilung des Zustands eines elektrischen Akkumulators herangezogen wird.

Der Erfindung liegt die Aufgabe zugrunde, ein Verfahren zur Ermittlung des Ladezustands eines Akkumulators anzugeben, welches großen Ladungsaustausch in Relation zur Kapazität, Ruhepausen und Standby-Phasen sowie Alterung erfasst und welches eine Ersatzschaltbildsimulation enthält, die insbesondere im Kfz eingesetzt werden kann, wo sich der Einsatz von Großrechnern verbietet.

Diese Aufgabe wird erfindungsgemäß beim eingangs genannten Verfahren durch die kennzeichnenden Merkmale des Anspruchs 1 gelöst. In den Unteransprüchen sind weitere vorteilhafte Ausgestaltungen des Verfahrens angegeben.

In dem Ersatzschaltbild-Modell, das in dem erfindungsgemäßen Verfahren genutzt wird, werden die Diffusionsprozesse durch Warburgimpedanzen beschrieben. In allen Systemen spielen Diffusionshemmungen eine sehr bedeutende Rolle. Dies betrifft sowohl die Diffusion von Komponenten im Elektrolyten wie auch Diffusionsvorgänge in den aktiven Materialien. Diese Mechanismen sind auch beim Bleiakkumulator von entscheidender Bedeutung, konkret die Säurediffusion und die Protonendiffusion im positiven Aktivmaterial $PbO_2$.

Die Diffusionsglieder werden somit im elektrischen Ersatzschaltbild als Serienschaltungen von Widerständen und Kapazitäten dargestellt. Eine Warburgimpedanz aus n Widerständen und Kondensatoren stellt physikalisch eine Aufteilung des Raumes, in dem der Diffusionsprozess abläuft, in n Schichten dar. Dabei repräsentieren die Widerstände die Hemmung des Diffusionsprozesses zwischen benachbarten Schichten, während die Kondensatoren die Speicherfähigkeit einer jeden Schicht beschreiben. Die Anzahl n der Schichten wird unter Abwägung der erforderlichen Genauigkeit einerseits und der Einfachheit der rechnerischen Behandlung andererseits festgelegt.

Das verwendete Ersatzschaltbild-Modell enthält im Einzelnen folgende Komponenten:

- Innenwiderstand Ri,
- eine Warburg-Impedanz We für die Säurediffusion im Akkumulator, und
- eine Parallelschaltung aus einer weiteren Warburg-Impedanz Wp für Diffusionsvorgänge in den aktiven Massen und einem Element D mit diodenähnlicher Kennlinie, das die kinetischen Abhängigkeiten des Akkumulators enthält,
- gegebenenfalls eine Konstantspannungsquelle Uo,

Dabei sind die Komponenten Wp und D parallel zueinander geschaltet und diese Parallelschaltung ist mit den Komponenten Uo, Ri und We in Serie geschaltet.

Dabei berücksichtigt die Konstantspannungsquelle Uo auch die Abhängigkeit der unbelasteten Akkumulatorspannung von der aktuellen Elektrolytkonzentration.

Die Warburg-Impedanz Wp für Diffusionsvorgänge enthält stromrichtungs- und spannungsabhängige Widerstände und das Element D besitzt eine diodenähnliche Kennlinie mit Durchlassrichtung bei Strömen in Entladerichtung des Akkumulators.

Die Warburg-Impedanzen We und Wp sind Bauelemente, die mindestens eine Parallelschaltung eines ersten Kondensators mit einer Serienschaltung aus einem Widerstand und einem weiteren Kondensator enthalten. Diesem und jedem weiteren Kondensator kann jeweils eine weitere Serienschaltung aus einem Widerstand und einem weiteren Kondensator parallelgeschaltet sein. Die Anzahl dieser Parallelschaltungen wird nach der gewünschten Genauigkeit gewählt.

Die mittlere Spannung Uwe an den Kondensatoren der Warburg-Impedanz We für die Säurediffuision wird als Maß für den Ladezustand SOC (State of Charge) des Akkumulators gewählt, wobei der Ladezustand SOC den Wertebereich von 0 (für den vollständig entladenen) bis 1 (für den vollständig geladenen Akkumulator) umfasst. Für den Ladezustand SOC einer einzelnen elektrochemischen Speicherzelle gilt etwa

$$SOC = Uwe / 0.2$$

Vorzugsweise wird fortwährend zeitgleich die Spannung U und die Temperatur T des Akkumulators sowie der durch ihn fließende Strom I gemessen. Dann wird ausgehend von einem bekannten Ladezustand des Akkumulators durch Variation der Parameter des Ersatzschaltbildmodells eine Minimierung der Differenz zwischen berechneter und gemessener Spannung U (z. B. nach der Methode der kleinsten Quadrate) durchgeführt und ein optimaler Satz von Parametern des Ersatzschaltbildmodells ermittelt.

Bei unbekanntem Ladezustand und bei bekannten Parametern des Ersatzschaltbildmodells wird ausgehend von einem geschätzten Ladezustand des Akkumulators, durch Variation des Ladezustandes in mehreren Durchläufen die Spannungsantwort des Ersatzschaltbildmodells solange berechnet und mit der gemessenen verglichen, bis berechnete und geschätzte Spannungen übereinstimmen.

Aus den so erhaltenen Werten von Ladezustand und Parametern des Ersatzschaltbildmodells wird auf die Belastbarkeit des Akkumulators geschlossen, diese Werte werden angezeigt, und/oder aus diesen Werten werden Konsequenzen für den Betrieb des Akkumulators und/oder des mit dem Akkumulator verbundenen Systems abgeleitet. Im Folgenden ist das erfindungsgemäße Verfahren anhand von Figuren näher erläutert. Soweit in diesen Beispielen konkrete Zahlenwerte genannt sind, beziehen diese sich auf einen 6-zelligen Bleiakkumulator mit einer Kapazität von 60Ah.

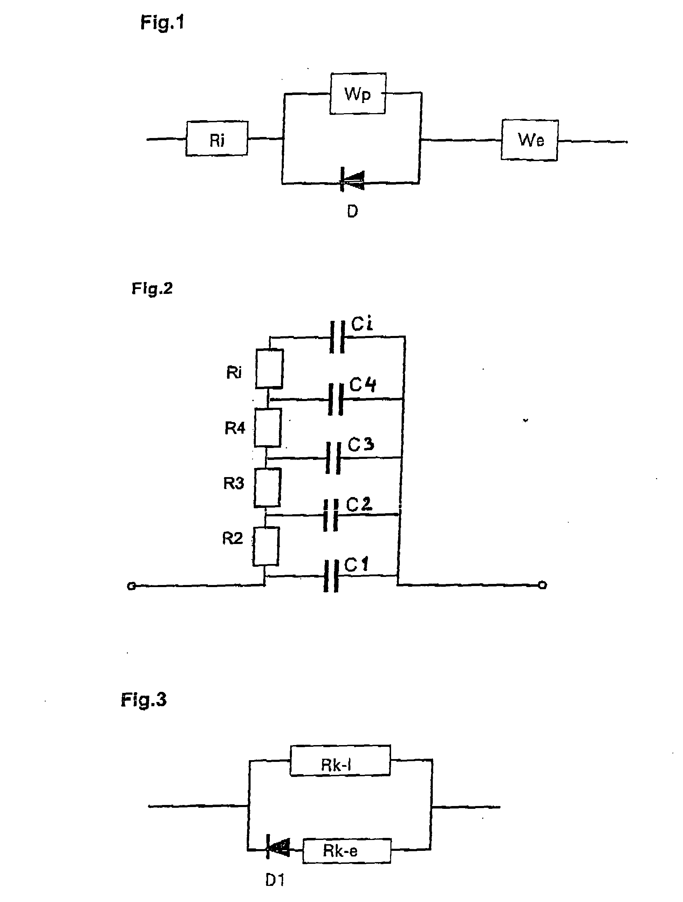

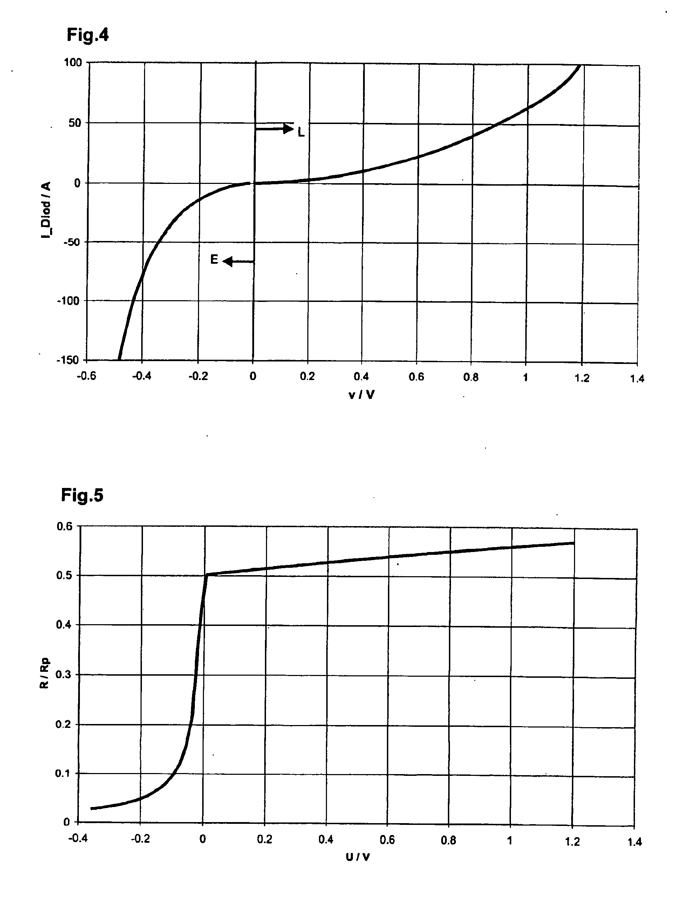

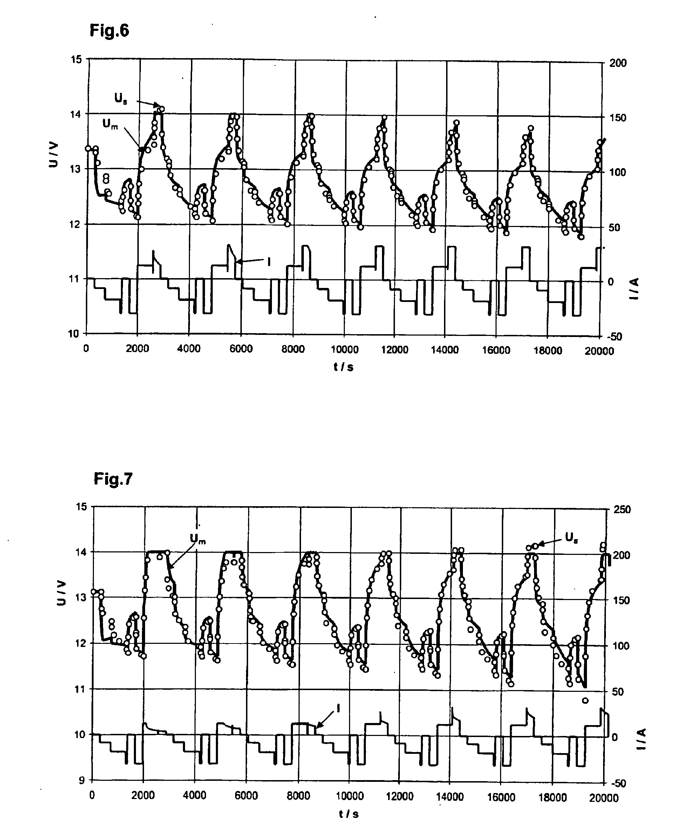

Figur 1 zeigt schematisch ein Ersatzschaltbild gemäß der Erfindung, Figur 2 den Aufbau einer Warburg-Impedanz, Figur 3 ein Ersatzschaltbild für die Widerstandsglieder in der Warburg-Impedanz, die Figuren 4 und 5 zeigen spezielle Kennlinien von im Ersatzschaltbildmodell verwendeten Bauelementen und Figuren 6 und 7 zeigen einen Vergleich zwischen am Beispielsakkumulator gemessenen Werten und den aus der Ersatzschaltbild-Simulation gewonnenen Werten.

Das erfindungsgemäße Ersatzschaltbildmodell ist in Figur 1 dargestellt. Es setzt sich grob zusammen aus einem ohmschen Widerstand Ri, einer Parallelschaltung einer Warburg-Impedanz Wp (Figur 2), welche die Diffusionsvorgänge beschreibt, und einem Schaltelement D mit grob diodenähnlichem Verhalten, welches einen großen Teil der kinetischen Lade-, Entlade- und Gasungs-Hemmungen des Akkumulators beschreibt, sowie einer zweite Warburg-Impedanz We, die die Säurediffusion beschreibt.

Der Widerstand Ri enthält neben den rein ohmschen Komponenten des Akkumulators wie Ableitwiderstände und Elektrolytwiderstand in der Separation, auch Widerstandsanteile der elektrochemischen Elektrodenreaktionen.

Die Diffusionsprozesse werden beschrieben, durch die Warburg-Impedanzen Wp und We. Deren Aufbau ergibt sich daraus, dass der "Diffusions"-Raum in n diskrete Schichten einer bestimmten Dicke eingeteilt wird und die Mengenbilanzen errechnet werden. Die Änderung der Spannung in einer Schicht während eines Zeitintervalls berechnet sich aus der Dicke der Schicht und der Dicke ihrer Nachbarschichten, den Spannungen an diesen, und den Widerständen zwischen den Schichten sowie den Kapazitäten der Schichten.

Der Bleiakkumulator polarisiert beim Laden stark, während er bei Entladung sogar oberhalb der Ruhespannung nur wenig Polarisation zeigt. Die Erfindung berücksichtigt dies dadurch, dass die (Diffusions-)Widerstände R der Warburg-Impedanz Wp je nach Stromrichtung variabel gewählt werden. In Figur 3 ist ein Ersatzschaltbild dieser Widerstände Rk dargestellt, mit dem Widerstand Rk-I (Ladung) und dem Widerstand Rk-e (Entladung) und der entsprechenden Entkopplungsdiode D1. Dieses Verhalten beim Laden bzw. Entladen ist unsymmetrisch, annähernd dem einer Diode.

Der je nach Stromrichtung veränderliche Diffusionswiderstand wird durch eine Funktion beschrieben, deren Verlauf für eine 6-zellige Starterbatterie mit einer Kapazität von 60 Ah in Figur 4 dargestellt ist.

Im Ladefall sind die R = Rp. Bei Entladung sind die R dagegen abhängig von der Spannung. Für negative Spannungswerte wird der Diffusionswiderstand R dabei sehr klein, wodurch die Warburg-Impedanz Wp fast zu einer reinen Kapazität wird.

Berücksichtigt werden auch kinetische Vorgänge, wie Entlade- und Ladekinetik des Durchtritts und die parasitären Gasungsreaktionen. Diese sind in dem Element D nachgebildet, da die Lade- und Entladekinetiken grobe Ähnlichkeit mit einer Diodenkennlinie haben.

Die einzelnen Abhängigkeiten sind beispielhaft in nachstehenden Gleichungen gegeben.
Die dabei verwendeten Formelzeichen stehen für folgende Größen:

v = Spannung über der Diode
vgr = "Grenzspannung" der Diode bei Entladung
Uwe = mittlere Spannung der Warburg-Impedanz für Säurediffusion, Maß für den Ladezustand.

Das Strom-/Spannungs-Verhalten des Elementes D für Spannungen v > 0 an dem Element D, d.h. für Ströme in Sperrrichtung, wird durch einen Zusammenhang ähnlich einem Potenzgesetz, vorzugsweise der ungefähren Abhängigkeit

$$I\_Diod := a\, v^b \;+\; I_g * exp(v/U_g)$$

nachgebildet, wobei a ein Parameter der Dimension Strom/Spannung$^b$ ist und wobei die dimensionslose Konstante b so gewählt wird, dass b > 1,5 und vorzugsweise b - 2 gilt. Ig und Ug sind Parameter, die die Gasung beschreiben. Der Parameter Ig ist von der Dimension Strom und der Parameter Ug von der Dimension Spannung und beide Parameter werden durch Variationen derart, dass Übereinstimmungen mit dem gemessenen Werten hergestellt wird, angepasst. Fig. 4 zeigt im Ladebereich ("L") einen typischen Verlauf der obigen Formel für eine 60Ah Akkumulator.

Die nachstehende Funktion für den Fall v<0 beschreibt ein Verhalten, das bei kleinen Überspannungen v die Entladung noch stark hemmt, dann aber mit steigendem Betrag der Überspannung v den Diodenstrom quadratisch anwachsen lässt, dies im Bereich der Grenzspannung vgr durch einen hyperbolischen Beitrag noch weiter verstärkt (Teilformel (A)), dann aber aus numerischen Gründen stetig in eine reine Parabel übergeht (B).

(A) falls (v<0) und $(v^2 \leq 0.99/vgr^2)$

$$dann\ I\_Diod := -d * v^2 / (vgr^2 - v^2)$$

(B) falls (v<0) und $(v^2 > 0.99 * vgr^2)$

$$\text{dann } I\_Diod := -d*(99 + 0.0001/vgr^2 \text{ mit diodenähnlicher Kennlinie } (v^2 - 0.99*vgr^2)).$$

Der Parameter d ist der die Diode beschreibende angepasste Parameter und wird ebenso wie der Parameter Schwellspannung vgr angepasst.

Eine solche Kennlinie ist in Figur 4 für das Beispiel des oben genannten Bleiakkumulators dargestellt. Die Figur zeigt im Entladebereich ("E") den typischen Verlauf des Diodenstroms I_Diod in Abhängigkeit von der Spannung v an der Diode

Bewährt hat sich alternativ auch ein Ansatz der ungefähren Form

$$I\_Diod = Io * \sinh(v/vgr)$$

wobei der Parameter Io die Dimension eines Stromes und der Parameter Schwellspannung vgr die Dimension einer Spannung hat und beide Parameter angepasst werden.

Die mittlere Spannung Uwe an der Warburg-Impedanz We für Säurediffusion ist ein Maß für den Ladezustand SOC.

Die bei Strom i geflossene Ladungsmenge kap := $\int i * dt$ verändert die mittlere Spannung Uwe an der Warburg-Impedanz We mit der Kapazität C, ausgehend von ihrem Anfangswert Start_Uwe entsprechend

$$Uwe := Start\_Uwe + kap/C.$$

Für den Ladezustand SOC gilt damit im Falle eines 6-welligen Bleiakkumulators

$$SOC = Uwe/1.2$$

Bei tiefen Ladezuständen SOC ergibt sich eine zunehmende stärkere Verminderung der Spannung unter gegebener Last als bei höheren Ladezuständen, bis bei sehr tiefen Ladezuständen die Spannung zusammenbricht. Es hat sich gezeigt, dass die Abweichungen am Entladeende näherungsweise durch einen mit dem Entladegrad stark zunehmenden Widerstand beschrieben werden können.

Die Widerstände der Warburg-Impedanz Wp für Diffusionsvorgänge sind stromrichtungsabhängig. Die Widerstandswerte der in der Warburg-Impedanz Wp verschalteten Widerstände Rk werden durch ein Ersatzschaltbild gemäß Figur 3 wiedergegeben, bestehend aus einem Widerstand Rk-I, der parallelgeschaltet zu einer Serienschaltung eines Widerstandes Rk-e mit einer idealen Diode D1 in Entladerichtung ist.

Vorzugsweise werden die Werte der Widerstände Rk-I für alle Widerstände R gleich gewählt. Die Werte der Widerstände Rk-e hängen von den Spannungen U an den benachbarten Kondensatoren C ab, insbesondere von dem Mittelwert der Spannungen U, wobei diese Abhängigkeit für alle Widerstände Rk-e die gleiche ist.

Rk-e wird für hohe positive Spannungen U vorzugsweise in gleicher Größenordnung wie Rk-I gewählt. Rk-e wird für niedrige Spannungen U vorzugsweise um mindestens eine Größenordnung kleiner als Rk-I gewählt. Als Übergang zwischen diesen Extremwerten wird vorzugsweise eine stetige und monotone Funktion gewählt. Einen typischen bewährten Verlauf zeigt Fig.5. Hierin ist R auf einen Maximalwert Rp bezogen, der gleichzeitig einer der Anpassungsparameter ist.

Zur Beschreibung der Temperaturabhängigkeit von Parametern und/oder Konstanten wird ein funktionaler Zusammenhang gewählt, der seinerseits Parameter und Konstanten enthält, und diese Parameter und Konstanten P iterativ optimiert, wobei die funktionale Abhängigkeit von der Temperatur vorzugsweise etwa die Form

$$P = Po * \exp(-To/T)$$

hat. Dabei hat die Größe Po die gleiche Dimension wie der Parameter P, und die Referenztemperatur To die Dimension einer Temperatur.

Die Qualität der Wiedergabe des Akkumulatorverhaltens durch das erfindungsgemäße Ersatzschaltbild-Modell ergibt sich aus den Figuren 6 und 7.

Die Figuren zeigen ein Beispiel für die Anwendung des Ersatzschaltbild-Modells auf eine Blei-Starter-Batterie mit einer Nennkapazität von 60Ah. In Fig. 6 befindet sich der Akkumulator auf einer Temperatur von 25°C, in Fig. 7 auf einer solchen von - 10° C.

Die durchgezogenen Linien stellen den aufgeprägten Strom I und den gemessenen Spannungsverlauf $U_m$ der Batterie dar. Die nicht ausgefüllten Punkte stellen die Spannungsantwort $U_s$ des angefitteten Ersatzschaltbild-Modells dar.

Das erfindungsgemäße Verfahren ermöglicht es kritische Belastungssituationen vorherzusagen. Das verwendete Ersatzschaltbild-Modell gibt das Akkumulatorverhalten wieder und es ist nur wenig Rechner-Speicherplatz erforderlich zur Nachbildung des Lade- und Entladeverhaltens eines Akkumulators.

## Patentansprüche

1. Verfahren zur Ermittlung der Belastbarkeit eines elektrischen Akkumulators durch Messung von Strom, Spannung und Temperatur und Vergleich der gemessenen Spannungen mit den entsprechenden mit einem Ersatzschaltbild-Modell des Akkumulators berechneten Spannungen, wobei die Parameter der Komponenten des Ersatzschaltbild-Modells oder Ladezustände des Akkumulators derart variiert werden, dass Übereinstimmung mit den gemessenen Werten hergestellt wird, und dass aus den so ermittelten angepassten Parametern oder angepasstem Ladezustand auf die Belastbarkeit geschlossen wird, **dadurch gekennzeichnet, dass** das Ersatzschaltbild-Modell des Akkumulators eine Reihenschaltung aus einem Innenwiderstand Ri, einer Parallelschaltung aus einer Warburg-Impedanz (Wp) für Diffusionsvorgänge in den aktiven Massen des Akkumulators und einem die kinetischen Abhängigkeiten des Akkumulators enthaltenen Element (D) mit diodenähnlicher Kennlinie und einer Warburg-Impedanz (We) für die Säurediffusion im Akkumulator, wobei die Warburg-Impedanz (Wp) stromrichtungs- und spannungsabhängige Widerstände enthält, das Element (D) in Durchlassrichtung bei Strömen in Entladerichtung des Akkumulators geschaltet ist, und die Warburg-Impedanzen (We) und (Wp) jeweils einen ersten Kondensator C dieser mindestens einen Serienschaltung und mindestens eine Serienschaltung aus einem Widerstand (Ri) und einem weiteren Kondensator (C) enthalten, wobei eine erste Serienschaltung dieser mindestens einen Serienschaltung parallel zu dem ersten Kondensator (C) und jede weitere Serienschaltung dieser mindestens einen Serienschaltung parallel zu einem weiteren Kondensator (Ci) einer jeweils exklusiv zugeordneten Serienschaltung dieser mindestens einen Serienschaltung geschaltet ist, und dass aus der mittleren Spannung (Uwe) an dem Kondensator der Warburg-Impedanz (We) für die Säurediffusion ein Maß für den Ladezustand (SOC) des Akkumulators abgeleitet wird und aus den so erhaltenen Werten des Ladezustands und der Parameter des Ersatzschaltbild-Modells auf die Belastbarkeit des Akkumulators geschlossen wird, dass diese Werte angezeigt werden, und/oder dass aus diesen Werten Konsequenzen für den Betrieb des Akkumulators und/oder des mit dem Akkumulator verbundenen Systems abgeleitet werden.

2. Verfahren nach Anspruch 1, **dadurch gekennzeichnet, dass** ausgehend von einem bekannten Ladezustand des Akkumulators durch Variation der Parameter des Ersatzschaltbild-Modells eine Minimierung der Differenz zwischen berechneter und gemessener Spannung U des Akkumulators, insbesondere nach der Methode der kleinsten Quadrate, durchgeführt und ein optimaler Satz von Parametern des Ersatzschaltbild-Modells ermittelt wird, und dass aus den so erhaltenen Werten von Parametern des Ersatzschaltbild-Modells auf die Belastbarkeit des Akkumulators geschlossen wird, dass die Werte angezeigt werden und/oder dass aus diesen Werten Konsequenzen für den Betrieb des Akkumulators und/oder des mit dem Akkumulator verbundenen Systems abgeleitet werden.

3. Verfahren nach Anspruch 1, **dadurch gekennzeichnet, dass** bei unbekanntem Ladezustand bei bekannten Parametern des Ersatzschaltbild-Modells ausgehend von einem geschätzten Ladezustand des Akkumulators, unter Variation des Ladezustandes in mehreren Durchläufen die Spannungsantwort des Ersatzschaltbild-Modells solange berechnet und mit der gemessenen verglichen wird, bis berechnete und geschätzte Spannungen übereinstimmen, und dass aus dem so erhaltenen Ladezustandswert auf die Belastbarkeit des Akkumulators geschlossen wird, dass diese Werte angezeigt werden, und/oder dass aus diesen Werten Konsequenzen für den Betrieb des Akkumulators und/oder des mit dem Akkumulator verbundenen Systems abgeleitet werden.

4. Verfahren nach einem der Ansprüche 1 und 3, **dadurch gekennzeichnet, dass** das Strom-/Spannungs-Verhalten des Elementes mit diodenähnlicher Kennlinie (D) für Spannungen v > 0 an dem Element mit diodenähnlicher Kennlinie (D), d. h. für Ströme in Sperrrichtung, der Funktion

$$I\_Diod := a\,v^b + Ig \cdot exp(v/Ug)$$

folgt, wobei die dimensionslose Konstante b so gewählt wird, dass b > 1,5, vorzugsweise b - 2 ist und Ig ein die Gasung des Akkumulators beschreibender Parameter der Dimension Strom. Ug ein die Gasung des Akkumulators beschreibender Parameter der Dimension Spannung und a ein Parameter der Dimension Strom/Spannung $^b$ ist, wobei die Parameter Ig, Ug und a angepasste Parameter sind.

5. Verfahren nach einem der Ansprüche 1 bis 3, **dadurch gekennzeichnet, dass** das Strom-/Spannungs-Verhalten des Elementes mit diodenähnlicher Kennlinie (D) für Spannungen v < 0 an dem Element mit diodenähnlicher Kennlinie (D), d. h. Ströme in Durchlassrichtung, durch die Funktion

(A) falls (v<0) und ($v^2 \le$ O.99 mit diodenähnlicher Kennlinie vgr$^2$

$$dann\ I\_Diod := -d \cdot v^2\, /\, (vgr^2 - v^2)$$

(B) falls (v<0) und ($v^2 > 0.99 \cdot vgr^2$)

$$dann\ I\_Diod := -d \cdot (99 + (0.0001/vgr^2) \cdot (v^2 - 0.99 \cdot vgr^2))$$

nachgebildet wird und vgr eine Schwellspannung ist, wobei d und vgr angepasste Parameter sind und d von der Dimension Zeit $^{-1}$ ist.

6. Verfahren nach einem der Ansprüche 1 bis 4, **dadurch gekennzeichnet, dass** das Strom-/Spannungs-Verhalten des Elementes mit diodenähnlicher Kennlinie (D) für Spannungen v < 0 an dem Element mit diodenähnlicher Kennlinie (D), d .h für Ströme in Durchlassrichtung, durch die Funktion

$$I\_Diod := Io \cdot sinh\,(v/vgr)$$

nachgebildet wird und Io ein Parameter der Dimension Strom und vgr eine Schwellspannung ist, wobei Io und vgr angepassten Parameter sind.

7. Verfahren nach Anspruch 4, **dadurch gekennzeichnet dass** der Parameter a für Spannungen v an dem Element mit diodenähnlicher Kennlinie (D) mit v > 0, d.h. für Ströme in Sperrrichtung, vom Ladezustand SOC abhängt und vorzugsweise etwa entsprechend der Formel

$$a = (1 - SOC)^c \cdot a0$$

bestimmt wird, wobei der Ladezustand SOC zwischen einem Wert 1 im vollgeladenen Zustand des Akkumulators und einem Wert 0 im gänzlich entladenen Zustand variiert, der dimensionslose Exponent c etwa aus dem Wertebereich 0,5 < c < 2 gewählt wird, und a0 ein angepasstes Parameter der Dimension Strom/Spannung$^b$ mit der dimensionslosen Konstanten b ist.

8. Verfahren nach einem der Ansprüche 1 bis 7, **dadurch gekennzeichnet, dass** die Widerstandswerte der in der Warburg-Impedanz (Wp) verschalteten Widerstände (R) ihrerseits durch ein Ersatzschaltbild-Modell wiedergegeben werden, welches einen ersten Widerstand Rk-I parallel zu einer Serienschaltung eines zweiten Widerstands (Rk-e) und einer idealen Diode (D1) in Entladerichtung hat, wobei:

(a) alle ersten Widerstände (Rk-I) der in der Warburg-Impedenz (Wp) verschalteten Widerstände (R) gleich gewählt werden,

(b) die zweiten Widerstände (Rk-e) der in der Warburg-Impedanz (Wp) verschalteten Widerstände (R) von den Spannungen an den benachbarten Kondensatoren abhängen, insbesondere von deren Mittelwert und diese Abhängigkeit für alle Widerstände (Rk-e) gleich ist,

(c) die zweiten Widerstände (Rk-e) für hohe positive Spannungen in gleicher Größenordnung wie die ersten Widerstände (Rk-I) gewählt werden,

(d) die zweiten Widerstände (Rk-e) für niedrige Spannungen um mindestens eine Größenordnung kleiner als die ersten Widerstände (Rk-1) gewählt werden,

(e) als Übergang zwischen diesen Extremwerten vorzugsweise eine stetige und monotone Funktion verwendet wird.

## Claims

1. Method for determining the rating of an electric accumulator by measuring current, voltage and temperature and comparing the measured voltages with the corresponding voltages calculated by means of an equivalent circuit model of the accumulator, the parameters of the components of the equivalent circuit model or states of charge of the accumulator being varied in such a manner that correspondence with the measured values is established, and that from the adapted parameters thus determined or the adapted state of charge the rating is inferred, **characterized in that** the equivalent circuit model of the accumulator is a series circuit of an internal resistance Ri, a parallel circuit of a Warburg impedance (Wp) for diffusion processes in the active masses of the accumulator and an element (D) with diode-like characteristic, containing the kinetic dependences of the accumulator, and a Warburg impedance (We) for the acid diffusion in the accumulator, the Warburg impedance (Wp) containing current direction- and voltage-dependent resistances, the element (D) being switched in the forward direction with currents in the discharge direction of the accumulator, and the Warburg impedances (We) and (Wp) in each case containing a first capacitor (C) of this at least one series circuit and at least one series circuit of a resistance (Ri) and a further capacitor (C), a first series circuit of this at least one series circuit being connected in parallel with the first capacitor (C) and each further series circuit of this at least one series circuit being connected in parallel to a further capacitor (Ci) of an in each case exclusively allocated series circuit of this at least one series circuit, and **in that** from the mean voltage (Uwe) across the capacitor of the Warburg impedance (We) for the acid diffusion a measure of the state of charge (SOC) of the accumulator is derived and from the values of the state of charge and the parameters of the equivalent circuit model, thus obtained, the rating of the accumulator is inferred, **in that** these values are indicated and/or **in that** consequences for the operation of the accumulator and/or of the system connected to the accumulator are derived from these values.

2. Method according to Claim 1, **characterized in that,** starting with a known state of charge of the accumulator, a minimization of the difference between calculated and measured voltage U of the accumulator is carried out particularly in accordance with the method of least squares, by varying the parameters of the equivalent circuit model, and an optimum set of parameters of the equivalent circuit model is determined, and **in that** from the values of parameters of the equivalent circuit model thus obtained the rating of the accumulator is inferred, **in that** the values are indicated and/or **in that** consequences for the operation of the accumulator and/or of the system connected to the accumulator are derived from these values.

3. Method according to Claim 1, **characterized in that** in the case of an unknown state of charge, with known parameters of the equivalent circuit model, starting with an estimated state of charge of the accumulator, the voltage response of the equivalent circuit model is calculated by varying the state of charge in several runs, and compared with the measured voltage response, until the calculated and estimated voltages correspond and **in that** from the state of charge value thus obtained the rating of the accumulator is inferred, **in that** these values are indicated and/or **in that** consequences for the operation of the accumulator and/or of the system connected to the accumulator are derived from these values.

4. Method according to either of Claims 1 and 3, **characterized in that** the current/voltage behaviour of the element with diode-like characteristic (D), for voltages of v > 0 across the element with diode-like characteristic (D), i.e. for currents in the reverse direction, follows the function

$$I\_diod: = av^b + Ig* \exp(v/Ug)$$

where the dimensionless constant b is selected in such a manner that b > 1.5, preferably b - 2, and Ig is a parameter, describing the gassing of the accumulator, of the dimension current, Ug is a parameter, describing the gassing of the accumulator, of the dimension voltage and a is a parameter of the dimension current/voltage$^b$, where the parameters Ig, Ug and a are adapted parameters.

5. Method according to one of Claims 1 to 3, **characterized in that** the current/voltage behaviour of the element with diode-like characteristic (D) for voltages of v < 0 across the element with diode-like characteristic (D), i.e. currents in the forward direction is reproduced by the function

(A) if (v < 0) and ($v^2 \le 0.99$ with diode-like characteristic $vgr^2$

$$then\ I\_diod: = -d*v^2/(vgr^2 - v^2)$$

(B) if (v < 0) and ($v^2 > 0.99* vgr^2$)

$$then\ I\_diod:\ =\ -d*(99\ +\ (0.0001/vgr^2)\ *\ (v^2\ -\ 0.99* vgr^2))$$

and vgr is a threshold voltage, wherein d and vgr are adapted parameters and d has the dimension time$^{-1}$.

6. Method according to one of Claims 1 to 4, **characterized in that** the current/voltage behaviour of the element with diode-like characteristic (D), for voltages of v < 0 across the element with diode-like characteristic (D), i.e. for currents in the forward direction, is reproduced by the function

$$I\_diod: = Io * \sinh (v/vgr)$$

and Io is a parameter of the dimension current and vgr is a threshold voltage, where Io and vgr are adapted parameters.

7. Method according to Claim 4, **characterized in that** the parameter a for voltages v across the element with diode-like characteristic (D), with v > 0, i.e. for currents in the reverse direction, depends on the state of charge SOC and is preferably determined approximately in accordance with the formula

$$a = (1 - SOC)^c * a0$$

where the state of charge SOC varies between a value of 1 in the fully charged state of the accumulator and a value of 0 in the completely discharged state, the dimensionless exponent c is approximately selected from the range of values of 0.5 < c < 2 and a0 is an adapted parameter of the dimension current/voltage$^b$ with the dimensionless constant b.

8. Method according to one of Claims 1 to 7, **characterized in that** the resistance values of the resistances (R) interconnected in the Warburg impedance (Wp), in turn, are reproduced by an equivalent circuit model which has a first resistance Rk-I in parallel with a series circuit of a second resistance (Rk-e) and an ideal diode (D1) in the discharge direction, wherein:

(a) all first resistances (Rk-I) of the resistances (R) interconnected in the Warburg impedance (Wp) are selected to be equal,

(b) the second resistances (Rk-e) of the resistances (R) interconnected in the Warburg impedance (Wp) depend on the voltages across the adjacent capacitors, particularly on their mean value, and this dependence is equal for all resistances (Rk-e),

(c) the second resistances (Rk-e), for high positive voltages, are selected in the same order of magnitude as the first resistances (Rk-l),

(d) the second resistances (Rk-e), for low voltages, are selected to be smaller by at least one order of magnitude than the first resistances (Rk-l),

(e) a steady and monotonous function is preferably used as transition between these extreme values.

**Revendications**

1.  Procédé pour déterminer la capacité d'un accumulateur électrique par la mesure de l'intensité, de la tension et de la température et par la comparaison des tensions mesurées avec les tensions calculées sur un modèle de schéma équivalent de l'accumulateur,

    * les paramètres des composants du modèle de schéma équivalent ou des états de charge de l'accumulateur étant modifiés de façon à réaliser la concordance avec les valeurs mesurées, et
    * à partir des paramètres adaptés ou de l'état de charge adapté, ainsi déterminés, on détermine la capacité,

    **caractérisé en ce que**
    le modèle de schéma équivalent de l'accumulateur comprend un montage en série d'une résistance intérieure Ri, d'un montage en parallèle formé d'une impédance de Warburg (Wp) pour les opérations de diffusion dans les masses actives de l'accumulateur et d'un élément (D) contenant les relations cinématiques de l'accumulateur et ayant une courbe caractéristique analogue à celle d'une diode ainsi que d'une impédance de Warburg (We) pour la diffusion de l'acide dans l'accumulateur,
    selon lequel :

    * l'impédance de Warburg (Wp) comprend des résistances dépendant du sens de passage du courant et de la tension,
    * l'élément (D) est branché dans le sens passant pour les courants dans le sens de décharge de l'accumulateur, et
    * les impédances de Warburg (We) et (Wp) comportent respectivement un premier condensateur (C) au moins de ce montage en série et au moins un montage en série formé d'une résistance (Ri) et d'un autre condensateur (C),

    selon lequel :

    * un premier montage en série au moins de ce montage en série est branché en parallèle sur le premier condensateur (C) et chaque autre montage en série au moins d'un montage en série est branché en parallèle sur un autre condensateur (Ci) de chaque fois un montage en série associé de manière exclusive à au moins ce montage en série, et
    * à partir de la tension moyenne (Uwe) du condensateur de l'impédance de Warburg (We) pour la diffusion de l'acide, on déduit une mesure de l'état de charge (SOC) de l'accumulateur et à partir des valeurs ainsi obtenues de l'état de charge et des paramètres du modèle de schéma équivalent, on conclut à la capacité de l'accumulateur,
    * on affiche ces valeurs,
    * et/ou à partir de ces valeurs, on déduit des conséquences concernant le fonctionnement de l'accumulateur et/ou du système relié à l'accumulateur.

2.  Procédé selon la revendication 1,
    **caractérisé en ce qu'**
    à partir d'un état de charge connu de l'accumulateur, en modifiant les paramètres du modèle de schéma équivalent, on minimise la différence entre la tension U calculée et celle mesurée de l'accumulateur, notamment selon le procédé des moindres carrés et on détermine un jeu optimum de paramètres du modèle de schéma équivalent, et
    à partir des valeurs ainsi obtenues de paramètres du modèle de schéma équivalent, on conclut à la capacité de l'accumulateur,
    on affiche ces valeurs et/ou à partir de ces valeurs, on tire des conséquences concernant le fonctionnement de l'accumulateur et/ou du système relié à l'accumulateur.

**3.** Procédé selon la revendication 1,
**caractérisé en ce que**
pour un état de charge inconnu, partant de paramètres connus du modèle de schéma équivalent, à partir d'un état de charge évalué de l'accumulateur, en variant l'état de charge, au cours de plusieurs passages, on calcule la réponse en tension du modèle de schéma équivalent et on compare aux valeurs mesurées jusqu'à ce que les tensions évaluées et les tensions calculées concordent, et
à partir de la valeur de l'état de charge ainsi obtenu, on conclut à la capacité de l'accumulateur,
on affiche ces valeurs,
et/ou à partir de ces valeurs, on déduit les conséquences concernant le fonctionnement de l'accumulateur et/ou du système relié à l'accumulateur.

**4.** Procédé selon les revendications 1 et 3,
**caractérisé en ce que**
le comportement intensité/tension de l'élément ayant une courbe caractéristique (D) analogue à celle d'une diode pour les tensions v > 0 appliquées à l'élément ayant une caractéristique (D) analogue à celle d'une diode, c'est-à-dire pour les courants dans le sens bloquant, correspond à la fonction suivante :

$$\text{l\_Diod} := a \, v^b + \text{lg} * \exp(v/\text{Ug})$$

dans laquelle,
on choisit la constante b sans dimension de façon que b > 1,5 et de préférence b ~ 2 et 1g est un paramètre décrivant dans le dégazage de l'accumulateur ayant la dimension d'une intensité, Ug est un paramètre décrivant le dégazage de l'accumulateur ayant la dimension d'une tension, et a est un paramètre de la dimension intensité/tension $^b$, les paramètres lg, Ug et a étant des paramètres adaptés.

**5.** Procédé selon les revendications 1 à 3,
**caractérisé en ce que**
le comportement intensité/tension de l'élément ayant une courbe caractéristique (D) analogue à celle d'une diode, pour les tensions v < 0 appliquées à l'élément ayant une courbe caractéristique (D) analogue à celle d'une diode, c'est-à-dire les intensités du courant dans le sens passant, est représenté par la fonction suivante :

(A) si (v<0) et ($v^2 \leq 0,99$ avec une courbe caractéristique $vgr^2$ analogue à celle d'une diode),

$$\text{alors } \text{l\_Diod} := -d*v^2 \, / \, (vgr^2 - v^2)$$

(B) si (v<0) et ($v^2 > 0,99*vgr^2$),

$$\text{alors } \text{l\_Diod} := -d*(99 + (0,0001/vgr^2) * (v^2 - 0,99*vgr^2)),$$

et
vgr est une tension de seuil, d et vgr étant des paramètres adaptés et d ayant la dimension (temps$^{-1}$).

**6.** Procédé selon les revendications 1 à 4,
**caractérisé en ce que**
le comportement intensité/tension de l'élément ayant une courbe caractéristique (D) analogue à celle d'une diode pour les tensions v < 0 appliquées à l'élément ayant une courbe caractéristique (D) analogue à celle d'une diode, c'est-à-dire les courants dans le sens passant, est représenté par la fonction suivante :

$$l\_Diod := lo * \sinh(v/vgr)$$

et, lo est un paramètre ayant la dimension d'une intensité et vgr est une tension de seuil,
lo et vgr étant des paramètres adaptés.

**7.** Procédé selon la revendication 4,
**caractérisé en ce que**
le paramètre (a) pour les tensions v appliquées à l'élément ayant une courbe caractéristique (D) analogue à celle d'une diode avec v > 0, c'est-à-dire pour des courants dans le sens bloquant, dépend de l'état de charge SOC et correspond de préférence sensiblement à la formule suivante :

$$a = (1 - SOC)^c * a0$$

l'état de charge SOC variant entre une valeur 1 pour l'état de charge maximal de l'accumulateur et une valeur 0 pour l'état complètement déchargé,
l'exposant (c) sans dimension étant choisi dans une plage de valeurs telle que $0{,}5 < c < 2$, et
a0 est un paramètre adapté, ayant la dimension intensité/tension b avec des constantes b sans dimension.

**8.** Procédé selon les revendications 1 à 7,
**caractérisé en ce que**
les valeurs des résistances (R) de l'impédance de Warburg (Wp) sont reproduites elles-mêmes par un modèle de schéma équivalent qui a une première résistance (Rk-1) parallèle à un montage en série d'une seconde résistance (Rk-e) et une diode idéale (D1) dans le sens de la décharge, avec :

(a) toutes les premières valeurs (Rk-1) des résistances (R) de l'impédance de Warburg (Wp) étant choisies égales,
(b) les secondes valeurs (Rk-e) des résistances (R) de l'impédance de Warburg (Wp) dépendant des tensions des condensateurs voisins notamment de leur valeur moyenne et cette dépendance est la même pour toutes les résistances (Rk-e),
(c) les secondes valeurs des résistances (Rk-e) pour les tensions positives élevées étant choisies avec le même ordre de grandeur que les premières valeurs des résistances (Rk-1),
(d) les secondes résistances (Rk-e) pour les tensions basses étant choisies inférieures d'au moins un ordre de grandeur aux premières valeurs des résistances (Rk-1),
(e) la transition entre les valeurs extrêmes utilisant de préférence une fonction continue et monotone.

**Fig.1**

**Fig.2**

**Fig.3**

**Fig.4**

**Fig.5**

**Fig.6**

**Fig.7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 471698 B1
- WO 9013823 A

- JP 04095788 A

**In der Beschreibung aufgeführte Nicht-Patentliteratur**

- **P. Lürkens ; W. Steffens.** Ladezustandsschätzung von Bleibatterien mit Hilfe des Kalman-Filters. *ETZ Archiv,* 1986, vol. 8 (7), 231-236